# EUROPÄISCHE PATENTSCHRIFT

(11) **EP 2 106 426 B1**
(45) Veröffentlichungstag und Bekanntmachung des Hinweises auf die Patenterteilung: **25.04.2012**
(21) Anmeldenummer: 07858192.3
(22) Anmeldetag: 28.12.2007
(51) Int. Cl.: C09G 1/02, C09K 3/14, H01L 21/306

(54) **ZUSAMMENSETZUNG ZUM POLIEREN VON OBERFLÄCHEN AUS SILIZIUMDIOXID**
COMPOSITION FOR POLISHING SURFACE MADE OF SILICON DIOXIDE
COMPOSITION POUR POLIR DES SURFACES DE DIOXYDE DE SILICIUM

(30) Priorität: 28.12.2006 DE 102006061891
(43) Veröffentlichungstag der Anmeldung: 07.10.2009
(73) Patentinhaber: BASF SE, 67056 Ludwigshafen (DE)
(72) Erfinder: BEHRENS, Sven, Holger, Atlanta, Georgia 30317 (US); LIU, Yaqian, 67065 Ludwigshafen (DE); KERN, Günter, 67549 Worms (DE); DEBUS, Heidrun, 67304 Eisenberg (DE)
(86) Internationale Anmeldenummer: PCT/EP2007/064596
(87) Internationale Veröffentlichungsnummer: WO 2008/080958

(56) Entgegenhaltungen:
- US-A1- 2003 124 067
- US-A1- 2004 231 246
- US-B1- 6 616 514

## Beschreibung

Die vorliegende Erfindung betrifft eine stabilisierte Zusammensetzung zum Polieren von Oberflächen vorzugsweise von Halbleiter-Bauteilen, beispielsweise aus Siliziumdioxid, ein Verfahren zum Polieren sowie das chemisch-mechanische Planarisieren ("Chemical Mechanical Planarization") von Halbleitermaterialien.

Die immer kleiner werdenden Abmessungen von Bauteilen und Vorrichtungen und die zunehmende Integrationsdichte bei mikroelektronischen Schaltungen haben auch zu einer Verminderung der Größe von Isolationsstrukturen geführt. Diese Verminderung führt jedoch zu hohen Anforderungen bezüglich der reproduzierbaren Bildung von ebenen Oberflächen und Strukturen, die eine effektive Isolation bereitstellen, während ein minimales Ausmaß der Substratoberfläche belegt wird.

Zum Polieren, Reinigen, Schmirgeln und Planarisieren werden häufig wässrige Zusammensetzungen mit Schleifmitteln, so genannte "abrasive Slurries", verwendet, die feste Partikel in suspendierter Form enthalten. In vielen Fällen haben diese Partikel eine gegenüber dem umgebenden flüssigen Medium erhöhte Dichte und neigen daher zur Sedimentation. Sehr verbreitet sind beispielsweise wässrige Suspensionen anorganischer Schleifmittel.

Die darin enthaltenen Teilchen haben oft ein Vielfaches der Dichte von Wasser. Typische Werte rangieren z. B. von nahe 2,2 - 2,7 g/cm³ für Siliziumdioxid, ca. 3,4 g/cm³ für Siliziumnitrid, bis hin zu 15 g/cm³ für Wolframcarbid. Neben der Dichte der Schleifmittel haben auch die Größe und die Form der Schleifmittelteilchen einen Einfluss auf den Erfolg des Poliervorgangs.

Im Sinne einer effizienten Nachbehandlung der mit solchen Slurries bearbeiteten Materialien müssen die Zusammensetzungen zum einen eine hohe und vorzugsweise materialspezifische Abtragsrate (removal rate) aufweisen und Kratzer (scratches) weitgehend vermeiden, zum anderen sollten sie schnell und vollständig von der Oberfläche des Materials entfernbar sein, weshalb eine niedrige Viskosität zu den wesentlichen Anforderungen an die eingesetzten Slurries gehört.

So haben beispielsweise abrasive Slurries für das chemisch-mechanische Planarisieren (CMP), einem wichtigen Prozessschritt bei der Herstellung von Computer-Chips, typischerweise eine Viskosität von nicht mehr als 5 mPas.
Da durch Entmischungsvorgänge bei den eingesetzten Suspensionen eine Veränderung der Viskosität auftreten kann, besteht die Herausforderung, eine Stabilisierung dieser Zusammensetzungen zu erreichen und die Entmischung bzw. die Sedimentation von Slurry-Partikeln zu verhindern oder zu verzögern, ohne dabei die Viskosität deutlich zu erhöhen. Dieses ist gerade beim Einsatz von Schleifmitteln mit hoher Dichte schwierig. Verschiedene polymere Zusätze werden im Stand der Technik beschrieben.

Aus US 6,971,945 ist eine Zubereitung zur Polierung von Oberflächen von Halbleitern bekannt, bei der eine saure Suspension enthaltend ein Schleifmittel, ein Oxidationsmittel, ein anorganisches Salz und ein Komplexierungsmittel (wie zum Beispiel Phthalsäure) eingesetzt wird.

In DE-A 10 2005 058 272 wird ein Verfahren zum mehrstufigen chemischmechanischen Polieren von Oberflächen vorgestellt, bei dem nacheinander verschiedene Dispersionen von Metalloxid-Schleifmitteln in Wasser (zusammen mit Hilfsmitteln) auf Silica-Oberflächen aufgebracht werden.

Aus EP-A 0 373 501 ist der Einsatz von wasserlöslichen Polymeren in Poliermischungen bekannt, wobei diese zum Beispiel ein Molekulargewicht von 100.000 oder größer aufweisen und aus Polyvinylpyrrolidon oder zum Beispiel einem Pfropfcopolymer aus Guar Gum und Vinylmonomeren bestehen. Als Schleifmittel wird in den in EP-A 0 373 501 beschriebenen Poliermischungen kolloidales Silikat, das heißt ein Schleifmittel mit einer verhältnismäßig geringen Dichte eingesetzt.

Aus US 6,696,045 sind Zahnputzmittel bekannt.

Die in US 6,696,045 beschriebenen Zubereitungen zur Reinigung der Zähne enthalten neben einer Polyphosphatkomponente eine Metallsalzkomponente und ein organisches Geliermittel auf Basis von Polysacchariden. Der Einsatz von Ceroxid in Kombination mit den anderen Komponenten der erfindungsgemäßen Zusammensetzung wird jedoch nicht beschrieben.

In US 2005/0287931 wird eine Ceroxid-haltige Polierzusammensetzung beschrieben, die ein anionisches Dispergiermittel und eine nicht-ionische oberflächenaktive Verbindung enthält. Die darin verwendeten abrasiven Partikel haben eine mittlere Teilchengröße von 0,01 µm bis 10 µm.

In US 2003/0124067 wird eine Zahnputz-Zubereitung offenbart.

WO 2004/037934 und US 2004/231246 betreffen ferner Polierzusammensetzungen auf Basis von Ceroxid, die ein Dispergiermittel enthalten können.

Die dauerhafte und kostengünstige Stabilisierung von wässrigen Zusammensetzungen zum Polieren von Oberflächen ist eine Aufgabe der vorliegenden Erfindung.

Es wurde überraschend gefunden, dass diese Aufgabe durch die Einarbeitung kleiner Mengen von speziellen Gelier- bzw. Verdickungsmitteln in die wässrige Zusammensetzung gelöst werden kann.

Aus der Nahrungsmittelzubereitung sind verschiedene Geliermittel bekannt, die die Viskosität von Lösungen zum Teil erheblich beeinflussen können. Als Beispiele können z. B. Agar-Agar, Pektine, Polyosen, Alginate, Stärke, Dextrine, Gelatine und Casein genannt werden.

Es wird angenommen, dass die erfindungsgemäß zu verwendenden speziellen Geliermittel (G) in Konzentrationen unterhalb derer, die einen starken Viskositätsanstieg bewirken, bereits schwache Netzwerke ausbilden. Diese Netzwerke sind einerseits imstande, Teilchen in einer ruhenden Flüssigkeit suspendiert zu halten, andererseits aber durch die in bewegten Flüssigkeiten wirkenden Scherkräfte gelöst werden und daher die Fließfähigkeit nicht wesentlich beeinträchtigen.

In einem ersten Aspekt stellt die vorliegende Erfindung eine Zusammensetzung zum Polieren einer Oberfläche, zum Beispiel bei einem Halbleiter-Bauteil, bereit. Zum Planarisieren der Oberfläche kann dabei eine wässrige Zusammensetzung (Z) eingesetzt werden, die neben einer Schleifmittel-Komponente (S) mindestens ein Geliermittel (G) enthält.

Die Erfindung betrifft auch ein Verfahren zum Polieren einer Oberfläche (O) von Halbleiter-Bauteilen, bei dem zunächst eine wässrige Zusammensetzung (Z) auf die zu polierende Oberfläche (O) aufgebracht wird, wobei diese Zusammensetzung (Z) insbesondere die folgenden Komponenten enthält:
a) mindestens eine anorganische Schleifmittelkomponente (S), die ein Lanthaniden-Oxid mit einer Dichte von 3,5 bis 9 gl/cm³ enthält,
b) mindestens eine organische Dispergiermittelkomponente auf Polymerbasis (P),
c) mindestens ein organisches Geliermittel (G) auf Basis von Gellan Gum,
d) Wasser als Lösungs- bzw. Dispergiermedium, sowie
e) gegebenenfalls weitere Hilfs- und Zusatzstoffe.

Bei dem Polierverfahren werden die beim Poliervorgang gebildeten Schleifprodukte dann zusammen mit den Komponenten der Zusammensetzung (Z) nach dem Erreichen der gewünschten Planarisierung (P) durch einen einfachen Spülvorgang (V) von der polierten Oberfläche (O) entfernt.

Die zu polierende Oberfläche (O) kann aus unterschiedlichen Materialien bestehen, insbesondere den gängigen Materialien für Halbleiter-Bauteile. Vorzugsweise besteht sie z. B. aus Siliziumoxid, welches mit hoher Effizienz und Genauigkeit abgetragen werden kann.

Eine Ausführungsform der Erfindung bezieht sich auf ein Verfahren zum Polieren einer Oberfläche, dadurch gekennzeichnet, dass die Oberfläche (O) aus Siliziumoxid oder Siliziumnitrid besteht und als anorganische Schleifmittelkomponente (S) ein Lanthaniden-Oxid mit einer Dichte von 3,5 bis 9 g/cm³ eingesetzt wird.

In einer Ausführungsform der Erfindung wird eine Zusammensetzung (Z) eingesetzt, die als anorganische Schleifmittel-Komponente (S) ein anorganisches Lanthaniden-Oxid, insbesondere ein Ceroxid, bevorzugt Cerdioxid, enthält. Als Lanthaniden kommen im Prinzip Lanthan und die nachfolgenden Elemente (58 bis 70) in Frage, wobei geeignete Oxid-Verbindungen vorzugsweise eine Dichte von 3,5 bis 9 g/cm³, insbesondere von 5,0 bis 8,0 g/cm³ haben.

In einer Ausführungsform wird eine Zusammensetzung zum Polieren einer Oberfläche eingesetzt, dadurch gekennzeichnet, dass sie als anorganische SchleifmittelKomponente (S) Ceroxid oder eine Kombination von Ceroxid mit Zirkoniumoxid und/oder Manganoxid enthält.

In einer Ausführungsform der Erfindung wird eine Zusammensetzung (Z) eingesetzt, die als anorganische Schleifmittel-Komponente (S), eine Kombination von Ceroxid mit Zirkoniumoxid und/oder Manganoxid enthält.

In einer weiteren Ausführungsform der Erfindung wird eine Zusammensetzung (Z) eingesetzt, die als organische Dispergiermittelkomponente (P) ein Carbonsäurepolymer enthält. Als organische Polymerkomponente (P) kann z. B. ein Copolymer enthaltend die Monomeren Acrylsäure, Methacrylsäure und/oder Maleinsäure eingesetzt werden.

In einer bevorzugten Ausführungsform der Erfindung wird eine Zusammensetzung (Z) eingesetzt, die als organisches Geliermittel Gellan Gum enthält. Dabei kann die Zusammensetzung (Z) als organisches Geliermittel z. B. von 0,001 bis 1,0 Gew.%, bevorzugt von 0,01 bis 1,0 Gew.-%, insbesondere 0,05 bis 0,5 Gew.% an Gellan Gum enthalten. Das Gelliermittel Gellan Gum hat sich als besonders vorteilhaft bei der Stabilisierung der Zusammensetzungen (Z) erwiesen.

Die Erfindung betrifft auch ein Verfahren zum Polieren einer Oberfläche, bei dem die Zusammensetzung (Z) als organisches Geliermittel Gellan Gum und als anorganische Schleifmittel-Komponente (S) Ceroxid enthält. Diese Kombination hat sich aufgrund der besonders guten Haltbarkeit der Zusammensetzung bewährt.

Gegenstand ist auch eine Zusammensetzung (Z), die weitere Hilfs- und Zusatzstoffe enthält, beispielsweise ein Polyvinylpyrrolidon, kationische Verbindungen, Phthalsäure und/oder zwitterionische Verbindungen.

In einer Ausführungsform der Erfindung betrifft sie eine wässrige Zusammensetzung (Z), die folgende Komponenten enthält:
0,02 bis 6 Gew.-% des Schleifmittels Cerdioxid,
0,01 bis 5 Gew.-% mindestens eines Carbonsäurepolymers,
0,01 bis 1 Gew.-% mindestens eines Geliermittels (G), insbesondere Gellan Gum.

Die Zusammensetzung (Z) kann gegebenenfalls als Hilfs- und Zusatzstoffe z. B. auch enthalten:
0 bis 10 Gew.-% Polyvinylpyrrolidon,
0 bis 5 Gew.-% einer kationischen Verbindung,
0 bis 1 Gew.-% Phthalsäure oder Salze davon,
0 bis 5 Gew.-% einer zwitterionischen Verbindung
sowie als Lösungs- bzw. Dispergiermittel Wasser (ad 100 %).

Ein weiterer Gegenstand der Erfindung ist eine Zusammensetzung zum Polieren von Oberflächen enthaltend folgende Komponenten:
a) mindestens eine anorganische Schleifmittelkomponente (S), die ein Lanthaniden-Oxid mit einer Dichte von 3,5 bis 9 g/cm³ enthält, vorzugsweise Ceroxid,
b) mindestens eine organische Dispergiermittelkomponente (P), vorzugsweise ein Acrylsäure-Copolymer,
c) mindestens ein organisches Geliermittel (G), Gellan Gum,
d) Wasser als Lösungs- bzw. Dispergiermittel, sowie
e) gegebenenfalls weitere Hilfs- und Zusatzstoffe.

Hinsichtlich der Komponenten der Zusammensetzung zum Polieren einer Oberfläche wird auf die obige Beschreibung verwiesen.

Bevorzugt ist eine Zusammensetzung, die als anorganische Schleifmittel-Komponente (S) ein Lanthaniden-Oxid und als organisches Geliermittel (G) Gellan Gum enthält. Die Erfindung betrifft auch ganz allgemein die Verwendung von Gellan Gum zur Stabilisierung von wässrigen Zusammensetzungen zum Polieren von Oberflächen.

Die erfindungsgemäße Zusammensetzung zum Polieren enthält vorzugsweise 0,2 bis 6 Gew.-% der Schleifmittel-Komponente (S), um die Silica-Entfernung zu erleichtern. Das Schleifmittel wird gerne in einer Menge von 0,5 Gew.-% bis 5 Gew.-% eingesetzt.

Das Schleifmittel weist vorzugsweise eine durchschnittliche Teilchengröße von 50 bis 200 Nanometer (nm), insbesondere von 80 bis 150 nm, auf. Für die Zwecke dieser Beschreibung bezieht sich die Teilchengröße auf die durchschnittliche Teilchengröße des Schleifmittels. Es ist bevorzugt, als Schleifmittel Cerdioxid mit einer durchschnittlichen Teilchengröße von 80 bis 150 nm zu verwenden. Bei der Verminderung der Grö-βe des Schleifmittels auf weniger als 80 nm besteht eine Tendenz dahingehend, dass die Planarisierungswirkung der Polierzusammensetzung verbessert wird, jedoch auch dahingehend, dass die Entfernungsgeschwindigkeit der Schleifprodukte vermindert wird. Die Form der Teilchen ist vorzugsweise annähernd rund, insbesondere ohne bzw. mit wenigen Kanten. Auch hinsichtlich des Kristallisationsgrads und der Oberflächenladung der eingesetzten Teilchen können Unterschiede bei der Eignung festgestellt werden.

Beispiele für bekannte Schleifmittel umfassen anorganische Oxide, anorganische Hydroxide, Metallnitride, Metallboride, Metallcarbide und Gemische, die mindestens einen der vorstehend genannten Stoffe umfassen. Geeignete anorganische Oxide umfassen z. B. Silica (SiO₂), Aluminiumoxid (Al₂O₃), Zirkoniumoxid (ZrO₂) und Manganoxid (MnO₂). Erfindungsgemäß wird jedoch Ceroxid (CeO₂) und/oder ein anderes Lanthaniden-Oxid als Schleifmittel eingesetzt. Cerdioxid hat eine hohe Dichte (von ca. 7) und bevorzugte Abrieb-Eigenschaften.

Die Erfindung betrifft aber auch Zusammensetzungen mit Ceroxid in Kombinationen, die mindestens eines der vorstehend genannten Oxide zusätzlich umfassen. Modifizierte Formen dieser anorganischen Oxide wie z.B. polymerbeschichtete anorganische Oxidteilchen und anorganisch beschichtete Teilchen können gegebenenfalls ebenso verwendet werden. Geeignete Metallcarbide, -boride und -nitride umfassen z.B. Siliziumcarbid, Siliziumnitrid, Siliziumcarbonitrid (SiCN), Borcarbid, Wolframcarbid, Zirkoniumcarbid, Aluminiumborid, Tantalcarbid, Titancarbid oder Kombinationen, die mindestens eines der vorstehend genannten Metallcarbide, -boride und -nitride umfassen. Gegebenenfalls kann auch Diamant als zusätzliches Schleifmittel verwendet werden. Das bevorzugte Schleifmittel ist Ceroxid als Einzelkomponente. Auch bevorzugt ist der Einsatz von Ceroxid in Kombination mit einem anderen Lanthanidenoxid.

Als organische Dispergierkomponente (P) kommen verschiedene Polymere und Copolymere in Frage. Die erfindungsgemäße Zusammensetzung (Z) enthält vorzugsweise 0,01 bis 5 Gew.-% eines Carbonsäurepolymers, das als Dispergiermittel für die Schleifmittelteilchen dient.

Vorzugsweise enthält die Zusammensetzung 0,05 bis 1,5 Gew.-% eines Carbonsäurepolymers. Das Polymer weist vorzugsweise ein mittleres Molekulargewicht (Zahlenmittel) von 4.000 bis 1.500.000 auf.
Darüber hinaus können auch Blends von Carbonsäurepolymeren mit höherem und niedrigerem Molekulargewicht verwendet werden. Diese Carbonsäurepolymere liegen im Allgemeinen in Lösung vor, können jedoch auch in einer wässrigen Dispersion vorliegen. Das Carbonsäurepolymer kann in vorteilhafter Weise als Dispergiermittel für die Schleifmittelteilchen dienen. Das Zahlenmittel des Molekulargewichts der vorstehend genannten Polymere kann zum Beispiel mittels GPC bestimmt werden. Die Carbonsäurepolymere werden vorzugsweise aus ungesättigten Monocarbonsäuren und ungesättigten Dicarbonsäuren gebildet. Typische ungesättigte Monocarbonsäuremonomere enthalten 3 bis 6 Kohlenstoffatome und umfassen Acrylsäure, oligomere Acrylsäure, Methacrylsäure, Crotonsäure und Vinylessigsäure. Typische ungesättigte Dicarbonsäuren enthalten 4 bis 8 Kohlenstoffatome und umfassen deren Anhydride, wobei es sich z.B. um Maleinsäure, Maleinsäureanhydrid, Fumarsäure, Glutarsäure, Itaconsäure, Itaconsäureanhydrid und Cyclohexendicarbonsäure handelt. Darüber hinaus können auch wasserlösliche Salze der vorstehend genannten Säuren verwendet werden.

Besonders geeignet sind "Poly(meth)acrylsäuren" mit einem mittleren Molekulargewicht von etwa 1.000 bis 1.500.000, vorzugsweise 3.000 bis 250.000 und bevorzugt 20.000 bis 200.000. Der Ausdruck "Poly(meth)acrylsäure" ist hier als Polymere von Acrylsäure, Polymere von Methacrylsäure oder Copolymere aus Acrylsäure und Methacrylsäure definiert. Diese können auch Maleinsäure als Monomerkomponente enthalten. Auch verschiedene Blends von Poly(meth)acrylsäuren mit verschiedenem Molekulargewicht sind geeignet.

Darüber hinaus können als organische Polymerkomponente (P) auch Carbonsäureenthaltende Copolymere und Terpolymere verwendet werden, in denen die Carbonsäurekomponente z. B. 5 bis 75 Gew.-% des Polymers umfasst.

Typische Beispiele solcher Polymere sind Polymere aus (Meth)acrylsäure und Acrylamid oder Methacrylamid;

Polymere aus (Meth)acrylsäure und Styrol und anderen vinylaromatischen Monomeren; Polymere aus Alkyl(meth)acrylaten (Ester von Acryl- oder Methacrylsäure) und einer Mono- oder Dicarbonsäure, wie z.B. Acryl- oder Methacrylsäure oder Itaconsäure; Polymere aus substituierten vinylaromatischen Monomeren mit Substituenten wie z.B. Halogen (d.h. Chlor, Fluor, Brom), Nitro, Cyano, Alkoxy, Halogenalkyl, Carboxy, Amino, Aminoalkyl, und einer ungesättigten Mono- oder Dicarbonsäure und einem Alkyl(meth)acrylat;

Polymere aus monoethylenisch ungesättigten Monomeren, die einen Stickstoffring enthalten, wie z.B. Vinylpyridin, Alkylvinylpyridin, Vinylbutyrolactam, Vinylcaprolactam, und einer ungesättigten Mono- oder Dicarbonsäure; Polymere aus Olefinen, wie z.B. Propylen, Isobutylen oder langkettigen Alkylolefinen mit 10 bis 20 Kohlenstoffatomen, und einer ungesättigten Mono- oder Dicarbonsäure, Polymere aus Vinylalkoholestern, wie z.B. Vinylacetat und Vinylstearat oder Vinylhalogeniden, wie z.B. Vinylfluorid, Vinylchlorid, Vinylidenfluorid, oder Vinylnitrilen, wie z.B. Acrylnitril und Methacrylnitril, und einer ungesättigten Mono- oder Dicarbonsäure; Polymere aus Alkyl(meth)acrylaten mit 1 bis 24 Kohlenstoffatomen in der Alkylgruppe und einer ungesättigten Monocarbonsäure, wie z.B. Acrylsäure oder Methacrylsäure. Dabei handelt es sich nur um einige Beispiele aus der Vielzahl von Polymeren, die in der erfindungsgemäßen Zusammensetzung verwendet werden können.

Als Geliermittel können in der erfindungsgemäßen Polier-Zusammensetzung im Prinzip verschiedene handelsübliche Geliermittel eingesetzt werden, z. B. Agar-Agar, Pektine, Polyosen, Alginate, Stärke, Dextrine, Gelatine und Casein, jedoch haben sich Polysaccharide und insbesondere das Produkt Gellan Gum besonders bewährt.

Gellan Gum ist ein geruchloses, cremefarbenes Pulver, das gut löslich ist. Es ist ein multifunktionelles Geliermittel. Gellan Gum ist ein wasserlösliches Polysaccharid, hergestellt durch die aerobe Fermentation der Mikro-Organismen Sphingomonas elodea. Gellan Gum wird unter anderem in Lebensmitteln als Verdicker und Stabilisator eingesetzt.

Das gegebenenfalls als weitere Komponente eingesetzte Polyvinylpyrrolidon hat vorzugsweise ein durchschnittliches Molekulargewicht von 100 g/mol bis 1.000.000 g/mol. Das Gewichtsmittel des Molekulargewichts des Polyvinylpyrrolidons beträgt insbesondere 500 bis 800.000 g/mol, bestimmt mittels Gelpermeationschromatographie (GPC). Vorzugsweise weist das Polyvinylpyrrolidon ein Gewichtsmittel des Molekulargewichts von 500 bis 500.000 g/mol auf. Mehr bevorzugt beträgt das Gewichtsmittel des Molekulargewichts des Polyvinylpyrrolidons etwa 1.500 bis etwa 100.000 g/mol.

Die in den erfindungsgemäßen Zusammensetzungen (Z) eingesetzten Verbindungen stellen in Lösungen, die als Rest Wasser enthalten, eine Wirksamkeit über einen breiten pH-Bereich bereit. Der geeignete pH-Bereich dieser Lösungen erstreckt sich von 4 bis 9. Darüber hinaus wird zur Herstellung der Zusammensetzungen (Z) vorzugsweise entionisiertes Wasser verwendet, um zufällige Verunreinigungen zu beschränken.

Der pH-Wert beträgt vorzugsweise von 4,5 bis 8 und bevorzugt liegt ein pH-Wert von 5,5 bis 7,5 vor. Die Säuren, die zur Einstellung des pH-Werts der erfindungsgemäßen Zusammensetzung verwendet werden, sind z.B. Salpetersäure, Schwefelsäure, Chlorwasserstoffsäure und Phosphorsäure. Beispiele für Basen, die zur Einstellung des pH-Werts der erfindungsgemäßen Zusammensetzungen (Z) verwendet werden, sind z.B. Ammoniumhydroxid und Kaliumhydroxid.

Gegebenenfalls enthält die Zusammensetzung (Z) auch noch als Zusatz 0 bis 5 Gew.-% einer zwitterionischen Verbindung, um die Planarisierung zu fördern und die Nitridentfernung zu unterdrücken. Die Zusammensetzung enthält vorzugsweise 0,01 bis 1,5 Gew.-% einer zwitterionischen Verbindung. Die zwitterionische Verbindung der vorliegenden Erfindung kann in vorteilhafter Weise die Planarisierung fördern und die Nitridentfernung unterdrücken.

Gegebenenfalls kann die erfindungsgemäße Zusammensetzung (Z) auch als Hilfskomponente einen Zusatz von 0 bis 5 Gew.-% einer kationischen Verbindung. Vorzugsweise umfasst die Zusammensetzung gegebenenfalls 0,01 bis 1,5 Gew.-% einer kationischen Verbindung. Die kationische Verbindung der vorliegenden Erfindung kann in vorteilhafter Weise die Planarisierung fördern, die Waferabtragungszeit regulieren und dient zur Unterdrückung der Oxidentfernung. Bevorzugte kationische Verbindungen umfassen Alkylamine, Arylamine, quartäre Ammoniumverbindungen und Alkoholamine.

Beispiele für kationische Verbindungen umfassen Methylamin, Ethylamin, Dimethylamin, Diethylamin, Trimethylamin, Triethylamin, Anilin, Tetramethylammoniumhydroxid, Tetraethylammoniumhydroxid, Ethanolamin und Propanolamin.

Gegebenenfalls kann die erfindungsgemäße Zusammensetzung (Z) zusätzlich als Zusatz 0 bis 1 Gew.-% eines Komplexierungsmittels enthalten.

Vorzugsweise enthält die Zusammensetzung 0,01 bis 0,5 Gew.-% eines Komplexierungsmittels. Beispiele für Komplexierungsmittel umfassen Carbonylverbindungen (z.B. Acetylacetonate und dergleichen), einfache Carboxylate (z.B. Acetate, Arylcarboxylate und dergleichen), Carboxylate, die eine oder mehrere Hydroxylgruppe(n) enthalten (z.B. Glykolate, Lactate, Glukonate, Gallensäure und Salze davon und dergleichen), Di-, Tri- und Polycarboxylate (z.B. Oxalate, Phthalate, Citrate, Succinate, Tartrate, Malate, Edetate (z.B. Dinatrium-EDTA), Gemische davon, Carboxylate, die eine oder mehrere Sulfon- und/oder Phosphonsäuregruppe(n) enthalten.

Andere geeignete Komplexierungsmittel umfassen z.B. Di-, Tri- oder Polyalkohole (z.B. Ethylenglykol, Brenzkatechin, Pyrogallol, Gerbsäure und dergleichen) und Phosphatenthaltende Verbindungen (z.B. Phosphoniumsalze und Phosphonsäuren). Vorzugsweise ist das Komplexierungsmittel Phthalsäure und/oder Salze davon. Bevorzugte Phthalatsalze umfassen Ammoniumhydrogenphthalat und Kaliumhydrogenphthalat und Gemische davon.

Auch Gegenstand der vorliegenden Erfindung ist ein Verfahren zur Herstellung einer Zusammensetzung zum Polieren von Oberflächen, bei dem die folgenden Komponenten:
a) mindestens eine anorganische Schleifmittelkomponente (S), die ein Lanthaniden-Oxid mit einer Dichte von 3,5 bis 9 g/cm³ enthält,
b) mindestens eine organische Dispergiermittelkomponente auf Polymerbasis (P),
c) mindestens ein organisches Geliermittel (G) auf Basis von Gellan Gum
d) Wasser als Lösungs- bzw. Dispergiermedium, sowie
e) gegebenenfalls weitere Hilfs- und Zusatzstoffe
miteinander bei einer Temperatur von 10 bis 95° C vermischt werden. Dies kann z. B. durch einen Ultraschallstab erfolgen. Der Mischvorgang dauert in der Regel zwischen 1 Minute und mehreren Stunden (z. B. 5h). Bevorzugt werden erst die Komponenten S, und P in Wasser vermischt und dann das Geliermittel G sowie die weiteren Komponenten zugegeben.

Die Erfindung bezieht sich auch auf ein Verfahren zum Polieren von Halbleiter-Bauteilen bzw. -Strukturen. In dem ersten Schritt kann als abrasive Aufschlämmung die Zusammensetzung (Z) verwendet werden. Die Aufschlämmung kann in einem "oben liegenden" Bereich eines Oxidfilms ein signifikant schnelleres Polieren zeigen als in einem "unten liegenden" Bereich eines Oxidfilms. Insbesondere kann der Poliervorgang selektiv hinsichtlich des Materials durchgeführt werden, so kann Siliciumnitrid deutlich weniger abgetragen werden als Siliciumoxid.

Die Poliergeschwindigkeit der Zusammensetzung nimmt vorzugsweise ab, wenn die Stufenhöhe des Oxids vermindert wird und eine Planarisierung erreicht ist. In einer bevorzugten Ausführungsform der Erfindung kann ein Endpunktsignal genutzt werden, um das Ende des ersten Schritts auszulösen.

Es können verschiedene Verfahren verwendet werden, einschließlich Endpunktsignale auf Reibungs- oder Motorstrombasis. Der Punkt, an dem die Planarisierung erreicht ist, kann auf der Basis von charakteristischen Merkmalen des Endpunktsignals bestimmt werden.

Am Ende des ersten Schritts ist die Oberfläche des Halbleiter-Bauteils durch eine im Wesentlichen planare Oxidschicht gekennzeichnet, die den gesamten Wafer bedeckt. In dem zweiten Schritt erfolgt dann ein Abspülen der abrasiven Zubereitung. Der Endpunkt des zweiten Schritts kann auch durch einfache Tests bestimmt werden.

Die Zusammensetzung (Z) umfasst ferner gegebenenfalls als weitere Komponente ein Polyvinylpyrrolidon für eine verbesserte Dishing-Leistung.

Insbesondere stellt die vorliegende Erfindung eine wässrige Zusammensetzung bereit, die zum Polieren von Siliziumdioxid auf einem Halbleiterwafer geeignet ist.

Die Zusammensetzung enthält insbesondere 0,01-0,1 Gew.-% an Gellan-Gum, 0,01 bis 5 Gew.-% eines Carbonsäurepolymers, 0,02 bis 6 Gew.-% Schleifmittel, 0 bis 10 Gew.-% Polyvinylpyrrolidon, 0 bis 5 Gew.-% einer kationischen Verbindung, 0 bis 1 Gew.-% Phthalsäure und Salze davon, 0 bis 5 Gew.-% einer zwitterionischen Verbindung und als Rest Wasser.

Der Punkt, an dem die Planarisierung erreicht ist, kann auf der Basis charakteristischer Merkmale eines Endpunktsignals ermittelt werden. Durch Koppeln des Endpunktsignals mit der "inhibierenden" Aufschlämmung des ersten Schritts können die verbesserten Planarisierungseigenschaften aufrechterhalten werden, während verglichen mit dem Betrieb in einem richtigen Stopp-auf-Ebene-Modus höhere Poliergeschwindigkeiten und signifikant kürzere Verfahrenszeiten erhalten werden.

### Beispiel 1

### Messung der Dispersionsstabilität der erfindungsgemäßen Zubereitungen mittels Lumifuge 116

Die Lumifuge (Hersteller: Lum GmbH, 12489 Berlin) ist eine analytische Zentrifuge, die Entmischungsprozesse während der Zentrifugation über die gesamt Probenhöhe detektiert. Es können z.B. 8 Proben gleichzeitig untersucht werden.

Das Messprinzip der Lumifuge beruht auf einer Mikroprozessor-gesteuerten analytischen Zentrifuge, die das Separationsverhalten von Suspensionen und Emulsionen in Original-Konzentrationen zu beschreiben erlaubt. Die Zentrifugation bei 12- bis 1200-facher Erdbeschleunigung löst eine verstärkte Wanderung von Partikeln oder Bestandteilen der inneren Phase aus. Lokale Veränderungen der Partikelkonzentration werden durch Änderungen der Lichttransmission detektiert.

Die graphische Darstellung der Transmission als Funktion der lokalen Position ermöglicht Aussagen über korrespondierende Transmissionsprofile. Bereiche mit gut durchmischten Dispersionen streuen und absorbieren Licht, so dass die Transmission gering ausfällt. Im Gegensatz dazu erlaubt eine Aufklärung der Mischung, dass mehr Licht die Messzelle (CCD-Zelle) erreicht und damit die Transmission ansteigt. Mittels geeigneter Algorithmen zur Berechnung der Partikelgrößenverteilung kann eine auftretende Sedimentation, Flotation oder Aufklärung ausgewertet werden.

Die Proben werden in definierten Intervallen zwischen 10 Sekunden bis 24 Stunden analysiert. Als primäre Resultate ergeben sich korrespondierende Sequenzen von Profilen. Diese einzelnen Sequenzen werden dann mittels Software-Auswertung integriert und somit die Geschwindigkeit von Entmischungen dargestellt. Für die Quantifizierung der Entmischung wird die Lichttransmission durch die Küvette über die gesamte Probenhöhe gemessen. Dazu wird die Küvette mit einem parallelem Lichtblitz der Wellenlänge 800 bis 900 nm bestrahlt.

An dispersen Stoffen wird das Licht gebeugt oder absorbiert, während es durch die Klarphase ungehindert hindurchtreten kann. In Verlängerung von Lichtquelle und Küvette befindet sich ein optoelektronischer Sensor, die CCD-Zelle, welche Lichtintensität in Abhängigkeit von der Küvettenhöhe erfasst.

Diese ortsaufgelöste Messung der Lichttransmission wird im Abstand von 10 Sekunden wiederholt. Damit beobachtet man den Entmischungsvorgang direkt während der Zentrifugation. Die Entmischungskurve ist die graphische Darstellung der Phasengrenze als Funktion der Zeit. Die Steigung der Entmischungskurven spiegelt die Veränderung der Aufklarung wieder. Daraus berechnet ein elektronisches Datenverarbeitungsprogramm die Aufklarung (% Transmission pro Sekunde).

### Beispiel 2

### Verbesserung der Stabilität bei erfindungsgemäßen Zubereitungen (Slurries)

Es wurden verschiedene verkaufsfertige Polierzusammensetzungen (CMP-Slurries) jeweils mit 0,2 % Gew.-% Gellan Gum (Hersteller: Sigma-Aldrich Chemie GmbH, Taufkirchen, Deutschland) versetzt und die Stabilität der Proben vermessen.

Die Zugabe des Gellan Gum erfolgt bei Raumtemperatur. Die Probe wurde auf 85 bis 95 °C erhitzt und 3 bis 5 Stunden im geschlossenen System gerührt. Es folgte eine Abkühlen auf Raumtemperatur unter Rührung.

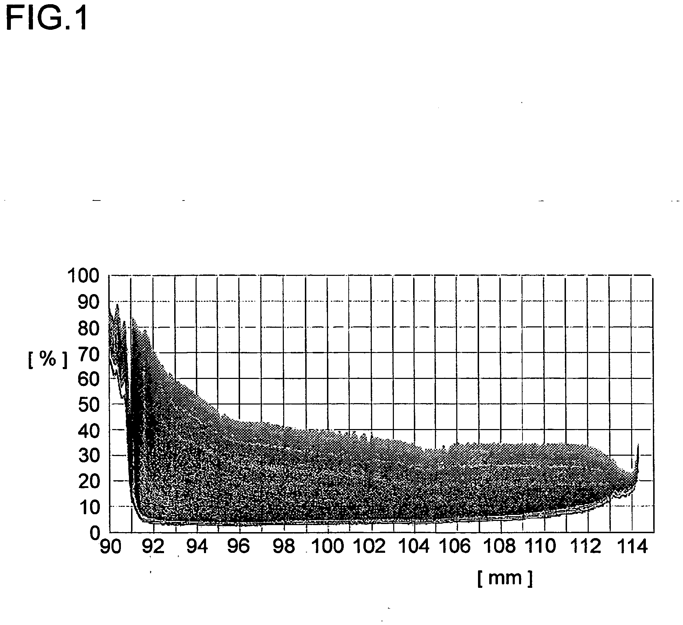

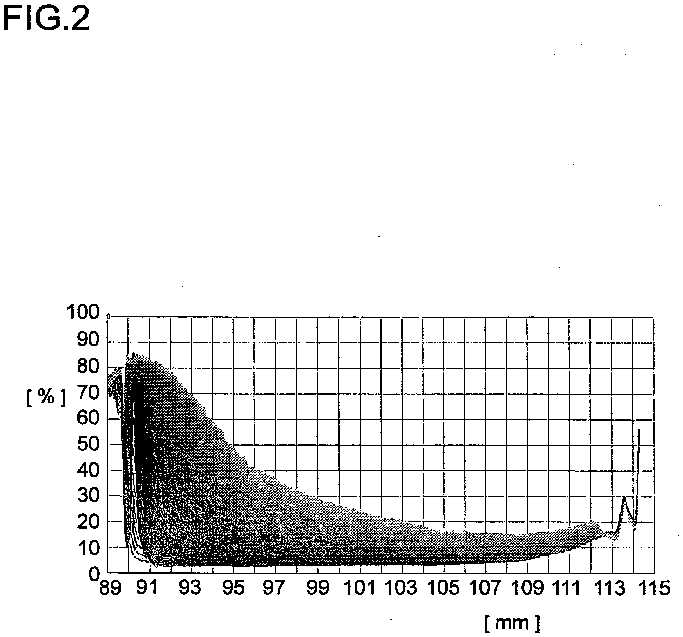

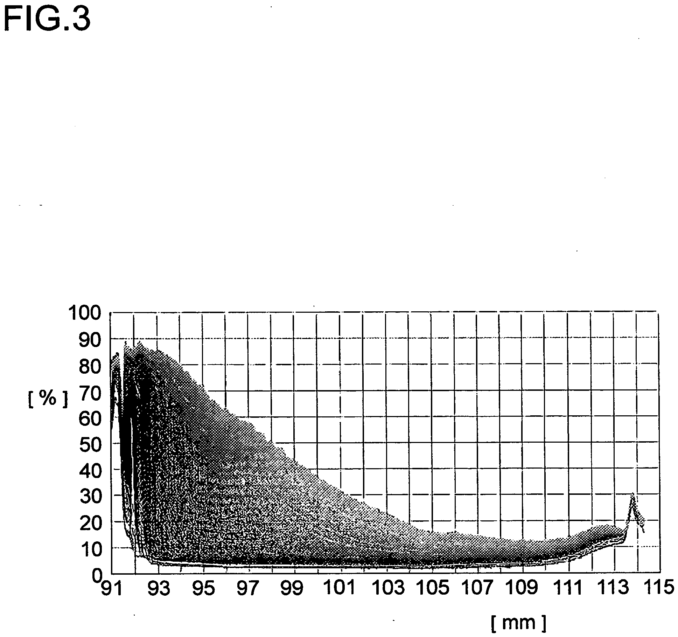

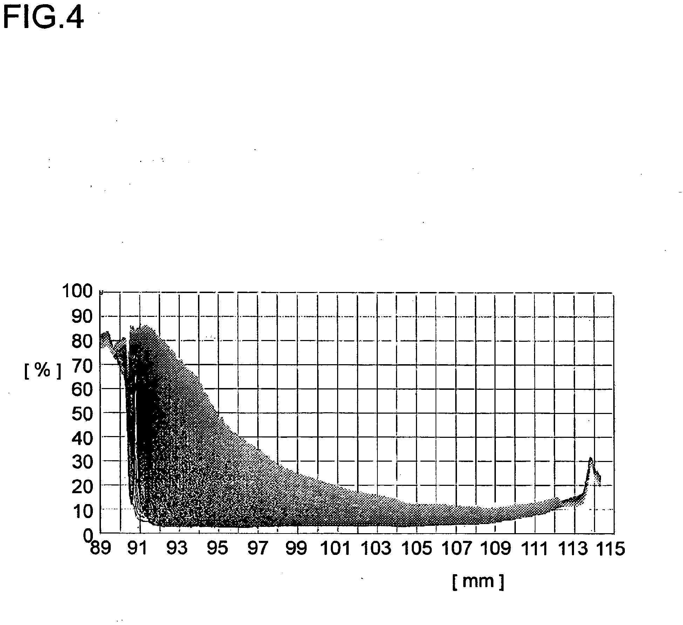

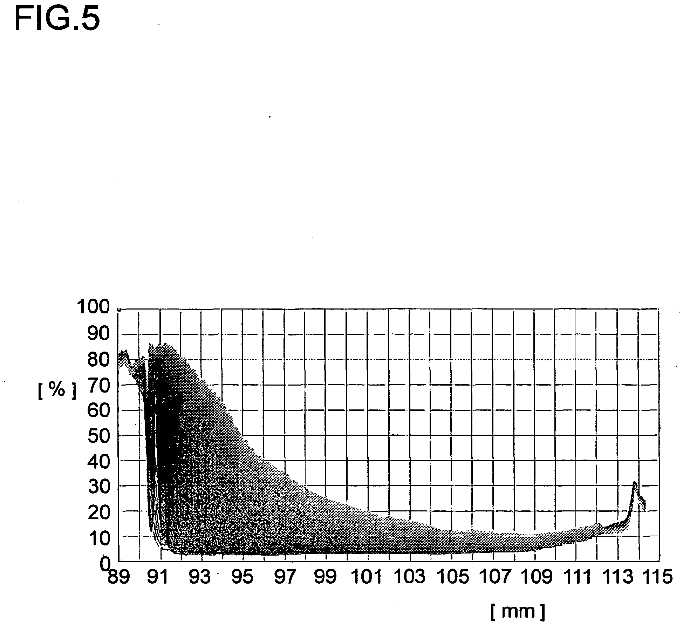

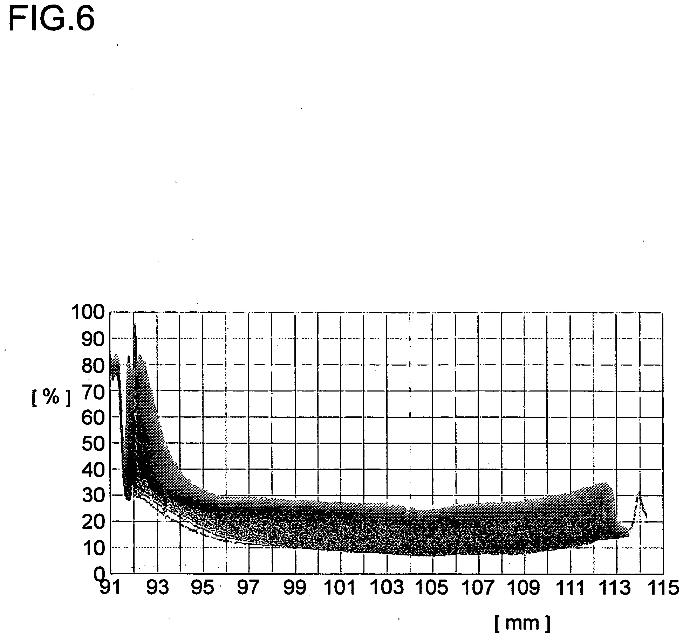

In den-Figuren 1 bis 6 sind die Ergebnisse der Stabilitätsuntersuchungen mittels Lumifuge an drei Zusammensetzungen (CMP-Slurries) jeweils ohne (Fig. 1, Fig. 3, Fig. 5) und mit (Fig. 1, Fig. 4, Fig. 6) Zusatz an Gellan-Gum wiedergegeben. Dabei wird in den Figuren die Transmission (in %) als Funktion der Position (in mm) wiedergegeben.

In Fig. 1 und 2 wird das Produkt "DP-7080HP" (R5; Hersteller: Nyacol Nano Technologies Inc; Ashland, USA) und in Fig. 3 und 4 das Produkt "DP-7090S" (R6; Hersteller: Nyacol Nano Technologies Inc.) eingesetzt.

In Fig. 5 und 6 wird das Produkt "Sokolan CP5" (R9; Hersteller: BASF) verwendet.

Die Bestimmung der Stabilität des CMP-Slurry mit der Lumifuge 116 zeigt eine deutliche Stabilisierung der Zusammensetzungen durch den Zusatz selbst geringer Mengen an Gellan Gum.

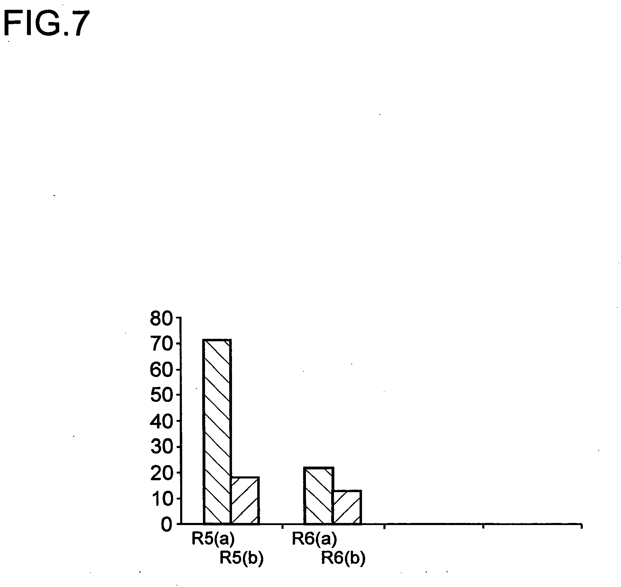

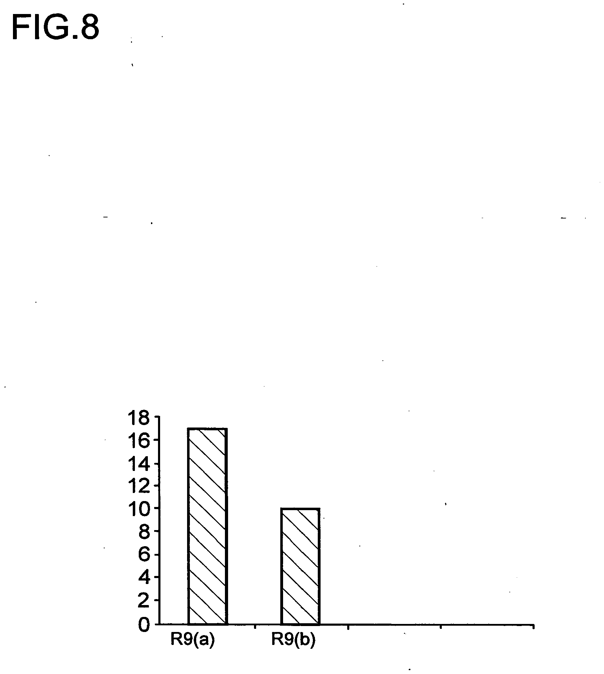

Die gemessene Verbesserung der Stabilität ist in den Figuren 7 und 8 grafisch verdeutlicht. Die Lichttransmission wird jeweils nach 3 Tagen im Vergleich für Slurries mit und ohne Gellan Gum in der Zusammensetzung dargestellt.

Es zeigt sich in Fig. 7 für die Probe R5 eine 75,7 %ige Stabilitätsverbesserung durch den Zusatz des Geliermittels. Es zeigt sich für die Probe R6 eine 44 %ige Stabilitätsverbesserung. In Fig. 8 wird die Stabilitätsverbesserung (Transmissions-Änderung) für "Sokolan CP5" mit Gellan Gum gezeigt.

### Beispiel 3

### Verbesserung der Stabilität einer erfindungsgemäßen Zusammensetzung (CMP-Slurry aus einem Pulver)

Die Formulierung eines CeO₂ Pulvers zu einem stabilen Slurry erfolgte wie folgt:

Zu vollentsalztem Wasser werden 0,1 Gew.-% eines Copolymers aus Acrylsäure und Maleinsäure (Dispergierhilfsmittel "Sokalan CP5", Hersteller BASF) und 5 Gew.-% eines Cerdioxid-Pulvers (Hersteller Degussa, "VP AdNano Ceria 50") unter Rühren zugegeben.

Nach 30-minütiger Dispergierung mit einem Ultraschallstab bei Raumtemperatur werden mit einem Magnetrührer 0,2 Gew.-% Gellan Gum Pulver (Hersteller: Sigma-Aldrich Chemie GmbH, Taufkirchen, Deutschland) in die Probe eingerührt. Die Probe wird für eine Stunde bei Raumtemperatur und anschließend für 4 Stunden bei 90 °C in einem geschlossenen Behälter gerührt, danach wird sie bei Raumtemperatur gelagert.

Die Sedimentationsstabilität wird über die Lichttransmission in einer Lumifuge 116 bestimmt (Umdrehungszahl 1500 rpm; Integrationszeit 1000 Sekunden) und mit der Stabilität einer Referenzprobe ohne Gellan Gum verglichen. Die Ergebnisse sind in Figur 8 gezeigt.

Ein Rückgang der integralen Transmission der mit Gellan Gum versetzten Proben um 46 % zeigt eine deutliche Verbesserung der Sedimentations-Stabilität durch das spezielle Geliermittel an.

### Beispiel 4

Die in Beispiel 3 beschriebene Zusammensetzung aus 94,7 % Wasser, 0,1 % Copolymer, 5 % Cerdioxid, 0,2 % Gellan Gum kann auf die Siliciumdioxid-Oberfläche eines Halbleiter-Bauteils aufgebracht und zum Polieren der Oberfläche eingesetzt werden.

## Patentansprüche

1. Zusammensetzung zum Polieren von Oberflächen enthaltend folgende Komponenten:
a) mindestens eine anorganische Schleifmittelkomponente (S), die ein Lanthaniden-Oxid mit einer Dichte von 3,5 bis 9 g/cm³enthält,
b) mindestens eine organische Dispergiermittelkomponente auf Polymerbasis (P),
c) als organisches Geliermittel (G) Gellan Gum,
d) Wasser als Lösungs-bzw. Dispergiermedium,
e) gegebenenfalls weitere Hilfs- und Zusatzstoffe.

2. Zusammensetzung zum Polieren einer Oberfläche gemäß Anspruch 1, **dadurch gekennzeichnet, dass** sie als anorganische Schleifmittel-Komponente (S) eine Kombination von Ceroxid mit Zirkoniumoxid und/oder Manganoxid enthält.

3. Zusammensetzung zum Polieren einer Oberfläche gemäß einem der Ansprüche 1 oder 2, **dadurch gekennzeichnet, dass** sie als anorganische Schleifmittel-Komponente (S) ein Lanthaniden Oxid mit einer Dichte von 5,0 bis 8,0 g/cm³ enthält.

4. Zusammensetzung zum Polieren einer Oberfläche gemäß einem der Ansprüche 1 bis 3, **dadurch gekennzeichnet, dass** sie als anorganische Schleifmittel-Komponente (S) Ceroxid oder eine Kombination von Ceroxid mit Zirkoniumoxid und/oder Manganoxid enthält.

5. Zusammensetzung zum Polieren einer Oberfläche gemäß einem der Ansprüche 1 bis 4, **dadurch gekennzeichnet, dass** die Zusammensetzung (Z) als organische Dispergierkomponente (P) ein Carbonsäurepolymer enthält.

6. Zusammensetzung zum Polieren einer Oberfläche gemäß einem der Ansprüche 1 bis 5, **dadurch gekennzeichnet, dass** die Zusammensetzung (Z) als organische Dispergierkomponente (P) ein Copolymer enthaltend die Monomeren Acrylsäure, Methacrylsäure und/oder Maleinsäure enthält.

7. Zusammensetzung zum Polieren einer Oberfläche gemäß einem der Ansprüche 1 bis 6, **dadurch gekennzeichnet, dass** die Zusammensetzung (Z) als organisches Geliermittel von 0,001 bis 1,0 Gew.-% an Gellan Gum enthält.

8. Zusammensetzung zum Polieren einer Oberfläche gemäß einem der Ansprüche 1 bis 7, **dadurch gekennzeichnet, dass** die Zusammensetzung (Z) als organisches Geliermittel Gellan Gum und als anorganische Schleifmittel-Komponente (S) Cerdioxid enthält.

9. Zusammensetzung zum Polieren einer Oberfläche gemäß einem der Ansprüche 1 bis 8, **dadurch gekennzeichnet, dass** die Zusammensetzung (Z) als weitere Hilfs- und Zusatzstoffe Polyvinylpyrrolidon, kationische Verbindungen, Phthalsäure und/oder zwitterionische Verbindungen enthält.

10. Zusammensetzung zum Polieren einer Oberfläche gemäß einem der Ansprüche 1 bis 9, **dadurch gekennzeichnet, dass** sie folgende Komponenten enthält: 0,02 bis 6 Gew.-% mindestens des Schleifmittels (S),
0,01 bis 5 Gew.-% mindestens des Carbonsäurepolymers,
0,01 bis 1 Gew.-% mindestens des Geliermittels (G)
sowie gegebenenfalls als Hilfs- und Zusatzstoffe,
0 bis 10 Gew.-% Polyvinylpyrrolidon,
0 bis 5 Gew.-% einer kationischen Verbindung,
0 bis 1 Gew.-% Phthalsäure oder Salze davon,
0 bis 5 Gew.-% einer zwitterionischen Verbindung
sowie als Lösungs- bzw. Dispergiermedium Wasser (ad 100 %).

11. Verfahren zum Polieren einer Oberfläche (O) von Halbleiter-Bauteilen, bei dem zunächst eine wässrige Zusammensetzung (Z) auf die zu polierende Oberfläche (O) aufgebracht wird, wobei diese Zusammensetzung (Z) die folgenden Komponenten enthält:
a) mindestens eine anorganische Schleifmittelkomponente (S), die ein Lanthaniden-Oxid mit einer Dichte von 3,5 bis 9 g/cm³ enthält,
b) mindestens eine organische Dispergiermittelkomponente auf Polymerbasis (P),
c) mindestens ein organisches Geliermittel (G) auf Basis von Gellan Gum,
d) Wasser als Lösungs- bzw. Dispergiermedium,
e) gegebenenfalls weitere Hilfs- und Zusatzstoffe,
und bei dem die beim Poliervorgang gebildeten Schleifprodukte zusammen mit den Komponenten der Zusammensetzung (Z) nach dem Erreichen der gewünschten Planarisierung (P) durch einen einfachen Spülvorgang (V) von der polierten Oberfläche (O) entfernt werden können.

12. Verfahren zum Polieren einer Oberfläche gemäß Anspruch 11, **dadurch gekennzeichnet, dass** die Oberfläche (O) aus Siliziumoxid oder Siliziumnitrid besteht und als anorganische Schleifmittelkomponente (S) ein Lanthaniden-Oxid mit einer Dichte von 3,5 bis 9 g/cm³ eingesetzt wird.

13. Verfahren zum Polieren einer Oberfläche gemäß einem der Ansprüche 11 oder 12, **dadurch gekennzeichnet, dass** die Zusammensetzung (Z) als anorganische Schleifmittel-Komponente (S) Ceroxid enthält.

14. Verfahren zum Polieren einer Oberfläche gemäß einem der Ansprüche 11 bis 13, **dadurch gekennzeichnet, dass** die Zusammensetzung (Z) als organische Dispergierkomponente (P) ein Copolymer enthaltend die Monomeren Acrylsäure, Methacrylsäure und/oder Maleinsäure enthält.

15. Verfahren zum Polieren einer Oberfläche gemäß einem der Ansprüche 11 bis 14, **dadurch gekennzeichnet, dass** die Zusammensetzung (Z) als organisches Geliermittel von 0,001 bis 1,0 Gew.-% Gellan Gum enthält.

16. Verfahren zur Herstellung einer Zusammensetzung zum Polieren von Oberflächen, bei dem die folgenden Komponenten:
a) mindestens eine anorganische Schleifmittelkomponente (S), die ein Lanthaniden-Oxid mit einer Dichte von 3,5 bis 9 g/cm³ enthält,
b) mindestens eine organische Dispergiermittelkomponente auf Polymerbasis (P),
c) mindestens ein organisches Geliermittel (G) auf Basis von Gellan Gum,
d) Wasser als Lösungs- bzw. Dispergiermedium, sowie
e) gegebenenfalls weitere Hilfs- und Zusatzstoffe
miteinander bei einer Temperatur von 10 bis 95° C vermischt werden.

## Claims

1. A composition for polishing surfaces comprising the following components:
a) at least one inorganic abrasive component (S) comprising a lanthanide oxide having a density in the range from 3.5 to 9 g/cm³,
b) at least one organic dispersing-agent component based on polymer (P),
c) gellan gum as organic gelling agent (G),
d) water as solution or dispersing medium,
e) optionally further auxiliary and additive materials.

2. The composition for polishing a surface according to claim 1 comprising a combination of cerium oxide with zirconium oxide and/or manganese oxide as inorganic abrasive component (S).

3. The composition for polishing a surface according to either of claims 1 and 2 comprising a lanthanide oxide having a density in the range from 5.0 to 8.0 g/cm³ as inorganic abrasive component (S).

4. The composition for polishing a surface according to any one of claims 1 to 3 comprising cerium oxide or a combination of cerium oxide with zirconium oxide and/or manganese oxide as inorganic abrasive component (S).

5. The composition for polishing a surface according to any one of claims 1 to 4 comprising a carboxylic acid polymer as organic dispersing component (P).

6. The composition for polishing a surface according to any one of claims 1 to 5 comprising a copolymer comprising the monomers acrylic acid, methacrylic acid and maleic acid as organic dispersing component (P).

7. The composition for polishing a surface according to any one of claims 1 to 6 comprising from 0.001% to 1.0% by weight of gellan gum as organic gelling agent.

8. The composition for polishing a surface according to any one of claims 1 to 7 comprising gellan gum as organic gelling agent and cerium dioxide as inorganic abrasive component (S).

9. The composition for polishing a surface according to any one of claims 1 to 8 comprising polyvinylpyrrolidone, cationic compounds, phthalic acid and/or zwitterionic compounds as further auxiliary and additive materials.

10. The composition for polishing a surface according to any one of claims 1 to 9 comprising the following components:
0.02% to 6% by weight at least of the abrasive (S),
0.01% to 5% by weight at least of the carboxylic acid polymer,
0.01 % to 1% by weight at least of the gelling agent (G)
and also optionally as auxiliary and additive materials
0% to 10% by weight of polyvinylpyrrolidone,
0% to 5% by weight of a cationic compound,
0% to 1% by weight of phthalic acid or salts thereof,
0% to 5% by weight of a zwitterionic compound
and also as solution or dispersing medium water (ad 100%).

11. A process for polishing a surface (O) of semiconductor components wherein first an aqueous composition (Z) is applied to the surface (O) to be polished, this composition (Z) comprising the following components:
a) at least one inorganic abrasive component (S) comprising a lanthanide oxide having a density in the range from 3.5 to 9 g/cm³,
b) at least one organic dispersing-agent component based on polymer (P),
c) at least one organic gelling agent (G) based on gellan gum,
d) water as solution or dispersing medium,
e) optionally further auxiliary and additive materials,
and wherein the abrasion products formed in the course of the polishing operation can be removed from the polished surface (O) together with the components of the composition (Z) by a simple rinsing operation (V) after attainment of the desired planarization (P).

12. The process for polishing a surface according to claim 11 wherein the surface (O) consists of silicon oxide or silicon nitride and a lanthanide oxide having a density in the range from 3.5 to 9 g/cm³ is used as inorganic abrasive component (S).

13. The process for polishing a surface according to either of claims 11 and 12 wherein the composition (Z) comprises cerium oxide as inorganic abrasive component (S).

14. The process for polishing a surface according to any one of claims 11 to 13 wherein the composition (Z) comprises a copolymer comprising the monomers acrylic acid, methacrylic acid and/or maleic acid as organic dispersing component (P).

15. The process for polishing a surface according to any one of claims 11 to 14 wherein the composition (Z) comprises from 0.001% to 1.0% by weight of gellan gum as organic gelling agent.

16. A process for producing a composition for polishing surfaces, wherein the following components:
a) at least one inorganic abrasive component (S) comprising a lanthanide oxide having a density in the range from 3.5 to 9 g/cm³,
b) at least one organic dispersing-agent component based on polymer (P),
c) at least one organic gelling agent (G) based on gellan gum,
d) water as solution or dispersing medium,
e) optionally further auxiliary and additive materials
are mixed with one another at a temperature in the range from 10 to 95°C.

## Revendications

1. Composition pour polir des surfaces contenant les composants suivantes :
a) au moins un composant agent abrasif inorganique (S), qui contient un oxyde de lanthanide d'une densité de 3,5 à 9 g/cm³,
b) au moins un composant agent de dispersion organique à base d'un polymère (P),
c) de la gomme gellane en tant qu'agent gélifiant organique (G),
d) de l'eau en tant que solvant ou dispersant,
e) éventuellement d'autres adjuvants et additifs.

2. Composition pour polir une surface selon la revendication 1, **caractérisée en ce qu'**elle contient en tant que composant agent abrasif inorganique (S) une combinaison d'oxyde de cérium avec de l'oxyde de zirconium et/ou de l'oxyde de manganèse.

3. Composition pour polir une surface selon la revendication 1 ou 2, **caractérisée en ce qu'**elle contient en tant que composant agent abrasif inorganique (S) un oxyde de lanthanide d'une densité de 5,0 à 8,0 g/cm³.

4. Composition pour polir une surface selon l'une quelconque des revendications 1 à 3, **caractérisée en ce qu'**elle contient en tant que composant agent abrasif inorganique (S) de l'oxyde de cérium ou une combinaison d'oxyde de cérium avec de l'oxyde de zirconium et/ou de l'oxyde de manganèse.

5. Composition pour polir une surface selon l'une quelconque des revendications 1 à 4, **caractérisée en ce que** la composition (Z) contient en tant que composant agent de dispersion organique (P) un polymère d'acide carboxylique.

6. Composition pour polir une surface selon l'une quelconque des revendications 1 à 5, **caractérisée en ce que** la composition (Z) contient en tant que composant agent de dispersion organique (P) un copolymère contenant les monomères acide acrylique, acide méthacrylique et/ou acide maléique.

7. Composition pour polir une surface selon l'une quelconque des revendications 1 à 6, **caractérisée en ce que** la composition (Z) contient en tant qu'agent gélifiant organique de 0,001 à 1,0 % en poids de gomme gellane.

8. Composition pour polir une surface selon l'une quelconque des revendications 1 à 7, **caractérisée en ce que** la composition (Z) contient en tant qu'agent gélifiant organique de la gomme gellane et en tant que composant agent abrasif inorganique (S) du dioxyde de cérium.

9. Composition pour polir une surface selon l'une quelconque des revendications 1 à 8, **caractérisée en ce que** la composition (Z) contient en tant qu'adjuvants et additifs supplémentaires de la polyvinylpyrrolidone, des composés cationiques, de l'acide phtalique et/ou des composés zwitterioniques.

10. Composition pour polir une surface selon l'une quelconque des revendications 1 à 9, **caractérisée en ce qu'**elle contient les composants suivants :
0,02 à 6 % en poids au moins de l'agent abrasif (S),
0,01 à 5 % en poids au moins du polymère d'acide carboxylique,
0,01 à 1 % en poids au moins de l'agent gélifiant (G),
et éventuellement en tant qu'adjuvants et additifs
0 à 10 % en poids de polyvinylpyrrolidone,
0 à 5 % en poids d'un composé cationique,
0 à 1 % en poids d'acide phtalique ou ses sels,
0 à 5 % en poids d'un composé zwitterionique,
et en tant que solvant ou dispersant de l'eau (jusqu'à 100 %).

11. Procédé pour polir une surface (O) de composants semi-conducteurs, selon lequel une composition aqueuse (Z) est tout d'abord appliquée sur la surface à polir (O), cette composition (Z) contenant les composants suivantes :
a) au moins un composant agent abrasif inorganique (S), qui contient un oxyde de lanthanide d'une densité de 3,5 à 9 g/cm³,
b) au moins un composant agent de dispersion organique à base d'un polymère (P),
c) au moins un agent gélifiant organique (G) à base de gomme gellane,
d) de l'eau en tant que solvant ou dispersant,
e) éventuellement d'autres adjuvants et additifs,
et selon lequel les produits abrasifs formés pendant le processus de polissage peuvent être éliminés de la surface polie (0) avec les composants de la composition (Z) par un simple processus de rinçage (V) une fois la planarisation (P) souhaitée atteinte.

12. Procédé pour polir une surface selon la revendication 11, **caractérisé en ce que** la surface (O) est constituée d'oxyde de silicium ou de nitrure de silicium et un oxyde de lanthanide d'une densité de 3,5 à 9 g/cm³ est utilisé en tant que composant agent abrasif inorganique (S).

13. Procédé pour polir une surface selon l'une quelconque des revendications 11 ou 12, **caractérisé en ce que** la composition (Z) contient de l'oxyde de cérium en tant que composant agent abrasif inorganique (S).

14. Procédé pour polir une surface selon l'une quelconque des revendications 11 à 13, **caractérisé en ce que** la composition (Z) contient en tant que composant agent de dispersion organique (P) un copolymère contenant les monomères acide acrylique, acide méthacrylique et/ou acide maléique.

15. Procédé pour polir une surface selon l'une quelconque des revendications 11 à 14, **caractérisé en ce que** la composition (Z) contient en tant qu'agent gélifiant organique de 0,001 à 1,0 % en poids de gomme gellane.

16. Procédé de fabrication d'une composition pour polir des surfaces, selon lequel les composants suivantes :
a) au moins un composant agent abrasif inorganique (S), qui contient un oxyde de lanthanide d'une densité de 3,5 à 9 g/cm³,
b) au moins un composant agent de dispersion organique à base d'un polymère (P),
c) au moins un agent gélifiant organique (G) à base de gomme gellane,
d) de l'eau en tant que solvant ou dispersant, et
e) éventuellement d'autres adjuvants et additifs,
sont mélangés les uns avec les autres à une température de 10 à 95 °C.
